# EUROPEAN PATENT SPECIFICATION

(11) **EP 4 361 604 B1**
(45) Date of publication and mention of the grant of the patent: **05.08.2026**
(21) Application number: 22828436.0
(22) Date of filing: 22.06.2022
(51) Int. Cl.: G01R 33/32, G01N 24/10, G01R 33/60, G01N 21/64

(54) **FLUORESCENCE DETECTING DEVICE, AND FLUORESCENCE DETECTING METHOD**
FLUORESZENZERKENNUNGSVORRICHTUNG UND FLUORESZENZERKENNUNGSVERFAHREN
DISPOSITIF DE DÉTECTION DE FLUORESCENCE, ET PROCÉDÉ DE DÉTECTION DE FLUORESCENCE

(30) Priority: 23.06.2021 JP 2021104441
(43) Date of publication of application: 01.05.2024
(73) Proprietor: National Institutes for Quantum Science and Technology, Chiba 263-8555 (JP)
(72) Inventor: IGARASHI, Ryuji, Chiba-shi Chiba 263-8555 (JP); YANAGI, Tamami, Chiba-shi Chiba 263-8555 (JP); KAMINAGA, Kiichi, Chiba-shi Chiba 263-8555 (JP)
(74) Representative: Patentanwaltskanzlei WILHELM & BECK
(86) International application number: PCT/JP2022/024793
(87) International publication number: WO 2022/270520

(56) References cited:
- JP-A- 2011 180 570
- JP-A- 2012 211 811
- JP-A- 2021 510 837
- US-A1- 2018 120 219
- US-A1- 2019 277 842
- YANAGI TAMAMI, KAMINAGA KIICHI, SUZUKI MICHIYO, ABE HIROSHI, YAMAMOTO HIROKI, OHSHIMA TAKESHI, KUWAHATA AKIHIRO, SEKINO MASAKI, IM: "All-Optical Wide-Field Selective Imaging of Fluorescent Nanodiamonds in Cells, In Vivo and Ex Vivo", ACS NANO, AMERICAN CHEMICAL SOCIETY, US, vol. 15, no. 8, 24 August 2021 (2021-08-24), US , pages 12869 - 12879, XP093017272, ISSN: 1936-0851, DOI: 10.1021/acsnano.0c07740

## Description

### Technical Field

The present invention relates to a fluorescence detection device and a fluorescence detection method.

### Background Art

There are known analytical methods in which fluorescence emitted when excited electrons return to a ground state is used. For example, a diamond having a nitrogen-vacancy center (NV center), which contains nitrogen that substitutes for a carbon atom and a vacancy that is adjacent to the nitrogen, is known as a phosphor which allows the intensity of fluorescence emitted from the NV center to be controlled by magnetic resonance. Various methods of using a minute diamond (nanodiamond) having an NV center, such as use thereof as a marker or a magnetic sensor each of which generates fluorescence, have been studied.

In a case where a nanodiamond is used as a marker that generates fluorescence, there is a problem that it is difficult to distinguish between fluorescence emitted from an NV center and fluorescence emitted from the others. Patent Literature 1 discloses a fluorescence microscope that makes it possible to carry out selective field observation of fluorescence of interest. In this technique, an NV center included in a measurement target is irradiated with a high-frequency magnetic field so that the intensity of fluorescence emitted from the NV center is changed. This makes it possible to distinguish between the fluorescence which is emitted from the NV center and fluorescence which is emitted from an object other than the NV center and whose intensity does not change. US 2019/277842 A1 discloses a device for detecting target analytes. The device comprises a substrate with color centers contained therein, to the surface of which capture reagents are attached. Further provided is an optical source for generating excitation light, and means for fluorescence detection and signal processing. In addition, determining a relaxation time of a color center by optical measurement is disclosed. This is done by irradiating the color center with pulses of excitation light, whose time spacing is varied, and detecting the intensity of corresponding pulses of fluorescent light emitted by the color center.

### Citation List

### [Patent Literature]

[Patent Literature 1]
Japanese Patent Application Publication Tokukai No. 2011-180570

### Summary of Invention

### Technical Problem

However, in the above-described conventional technique, the intensity of a magnetic field is changed so that the intensity of fluorescence emitted from an NV center is changed. However, this method has a problem that a device configuration is complex and large-sized, because, in order to cause magnetic resonance of the NV center, it is necessary to simultaneously carry out irradiation with a microwave in addition to a device for generating the magnetic field and changing the intensity of the magnetic field.

The object of an aspect of the present invention is to provide a technique of identifying fluorescence emitted from a measurement target, with a simpler device configuration.

### Solution to Problem

In order to attain the above object, a fluorescence detection device in accordance with an aspect of the present invention includes the features set forth in claim

In order to attain the above object, a fluorescence detection method in accordance with an aspect of the present invention contains the features defined by claim 7.

### Advantageous Effects of Invention

According to an aspect of the present invention, it is possible to provide a technique of identifying fluorescence emitted from a measurement target, with a simpler device configuration.

### Brief Description of Drawings

Fig. 1 is a block diagram of a fluorescence detection device 1 in accordance with Embodiment 1 of the present invention.
Fig. 2 illustrates a relationship between the pulse frequency of pulsed laser light and the intensity of target light, in accordance with Embodiment 1.
Fig. 3 is a flowchart illustrating a flow of a fluorescence detection method S1 in accordance with Embodiment 1.
Fig. 4 is a block diagram of a fluorescence detection device 2 in accordance with Embodiment 2.
Fig. 5 is a block diagram of a fluorescence detection device 3 including a modulating section 12 that also has a function of an intensity modulating section 14.
Fig. 6 illustrates (i) a relationship between the pulse frequency of pulsed laser light that changes target light and the intensity of the target light and (ii) a relationship between the pulse intensity of pulsed laser light that changes background light and the intensity of the background light, in accordance with Embodiment 2.
Fig. 7 is a flowchart illustrating a flow of a fluorescence identification method S2 in accordance with Embodiment 1.
Fig. 8 shows a captured image of an in vitro sample and images obtained by processing the captured image, in accordance with Example 1.
Fig. 9 is a graph showing changes in fluorescence intensity derived from a NVC and rhodamine in the in vitro sample, in accordance with Example 1.
Fig. 10 is a differential intensity distribution of a difference image obtained from an even-numbered frame and an odd-numbered frame of the in vitro sample, in accordance with Example 1.
Fig. 11 shows images obtained in a case where fluorescent nanodiamonds were introduced into a HeLa cell stained with a JC-1 fluorescent dye, in accordance with Example 2.
Fig. 12 shows images obtained in a case where fluorescent nanodiamonds were introduced into *C. elegans,* in accordance with Example 3.
Fig. 13 shows zero-field splitting widths obtained by ODMR frequency spectra, in accordance with Example 3.
Fig. 14 shows images and evoked potentials obtained in a case where fluorescent nanodiamonds were introduced into an ex vivo hippocampus slice, in accordance with Example 4.
Fig. 15 shows fluorescence images obtained and processed in Example 5.

### Description of Embodiments

### Embodiment 1

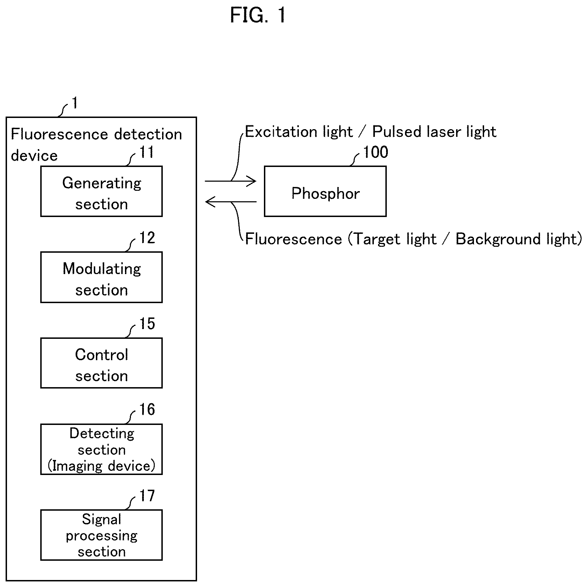

The following description will discuss, in detail, an embodiment of the present invention with reference to drawings. Fig. 1 is a block diagram of a fluorescence detection device 1 in accordance with Embodiment 1. As illustrated in Fig. 1, the fluorescence detection device 1 includes a generating section 11, a modulating section 12, a control section 15, a detecting section (imaging device) 16, and a signal processing section 17.

The generating section 11 generates pulsed laser light which causes spin polarization and spin relaxation in a phosphor that emits fluorescence whose intensity varies according to magnetic resonance. The phosphor is a substance which emits energy as visible light when an energy state of electrons of an atom or a molecule transitions from an excited state to a ground state. The phosphor that emits fluorescence whose intensity varies according to magnetic resonance is, for example, a phosphor that emits fluorescence whose intensity changes in a case where a spin state of electrons present in a crystal lattice defect is changed by magnetic resonance.

For example, in a case where a lattice defect structure in a diamond which lattice defect structure contains a nitrogen atom that substitutes for a carbon atom and a vacancy that is adjacent to the nitrogen atom (referred to as an NV center) is irradiated with green light (wavelength: 495 nm to 570 nm) or light having a wavelength twice the wavelength of the green light, electrons transition to an excited state, and then emit fluorescence of red light when the electrons return to a ground state. In this case, the NV center of the diamond is the phosphor, and the green light or the light having a wavelength twice the wavelength of the green light is excitation light that excites the phosphor.

Specifically, in the case of the NV center of the diamond, in a case where a spin magnetic quantum number in the ground state is mₛ=0, almost all of excited electrons transition to mₛ=0 in the ground state again while emitting fluorescence of 650 nm to 750 nm. In contrast, in a case where the spin magnetic quantum number is mₛ=±1, approximately 50% of the excited electrons undergo intersystem crossing to a singlet state, and transition to mₛ=0 in the ground state without emitting fluorescence. Therefore, in a case where photoexcitation is carried out for a sufficiently long time (several microseconds), almost 100% of triplet electrons are pumped to mₛ=0. This spin-dependent optical property causes a difference of approximately 5% to 10% in fluorescence intensity between a thermal equilibrium state and a pumped state. The following embodiment is described while the NV center of the diamond (hereinafter, simply referred to as "NV center") is taken as an example of a phosphor 100. Note that the diamond used for fluorescence measurement is a nano-sized diamond and, therefore, this diamond is also referred to as a fluorescent nanodiamond.

In the present embodiment, the pulsed laser light which is ejected in a pulsed manner (intermittently) is used to change the intensity of the fluorescence emitted from the NV center (measurement target). In a case where the NV center is irradiated with the pulsed laser light in green, the spin polarization and the spin relaxation occurs in the NV center. The spin polarization indicates a non-equilibrium state in which spin is present biasedly in a specific direction. The spin relaxation indicates a phenomenon in which non-equilibrium spin returns to an equilibrium state. This causes a change in the ratio between mₛ=0 and mₛ=±1, and therefore the intensity of the fluorescence emitted from the NV center is changed. Hereinafter, the fluorescence emitted from the measurement target is also referred to as "target light". Fluorescence emitted from an object other than the measurement target is also referred to as "background light".

The modulating section 12 has a role of changing the intensity of the fluorescence emitted from the NV center. Specifically, the modulating section 12 modulates the pulse frequency of the pulsed laser light. The pulse frequency is the number of ejections of pulses per unit time. By changing the pulse frequency, it is possible to change a degree of the spin relaxation. In the case of the NV center, the degree of the spin relaxation can be defined as the proportion of NV of mₛ=±1. As the degree of the spin relaxation becomes greater, the intensity of the fluorescence becomes lower. The range in which the modulating section 12 modulates the pulse frequency may be a range between 100 Hz and 200 MHz, preferably a range between 1 kHz and 1000 kHz, and more preferably a range between 10 kHz and 500 kHz. By modulating the pulse frequency in such a range, it is possible to carry out measurement with improved accuracy. In a case where the modulated pulse frequency falls below 100 Hz, a measurement time becomes long and time resolution decreases. Therefore, this is not preferable.

A pulse width (time for which a pulse is ejected) is not less than 100 ns. The pulse width is preferably 200 ns to 100 µs, and more preferably 300 ns to 10 µs. Each pulse may be continuous light, or may be pulsed light ejected intermittently. In the present disclosure, the intensity of the background light may or may not be changed. In the present embodiment, the intensity of the background light is not changed by making the number of ejections of pulses at each data point uniform and making the intensity of the pulses constant. Note that, in the present embodiment, the pulsed laser light also functions as excitation light and therefore the phosphor 100 does not need to be irradiated with excitation light for exciting the NV center.

As a specific configuration of the fluorescence detection device 1, the generating section 11 is, for example, a laser oscillator. The modulating section 12 is a signal generating section that generates a signal for oscillating laser light in a pulsed manner and modulating the pulse frequency of these pulses. The modulating section 12 transmits the generated signal to the generating section 11. With such a configuration, the fluorescence detection device 1 is capable of ejecting the pulsed laser light whose pulse frequency is modulated. The fluorescence detection device 1 irradiates the phosphor 100 with the pulsed laser light whose pulse frequency is modulated.

Note that a method in which the modulating section 12 modulates the pulsed laser light includes, for example, internal modulation and external modulation. The internal modulation is a method of ejecting the pulsed laser light whose pulse frequency is modulated, by carrying out oscillation in a pulsed manner in the generating section (laser oscillator) 11. The external modulation is a method of converting laser light ejected as continuous light into pulsed light having a given pulse frequency (or pulse intensity) via an acousto-optic modulator (AOM), an electro-optic modulator (EOM), or the like.

The control section 15 controls the entire fluorescence detection device 1. As the control section 15, any of various processors, such as a central processing unit (CPU), a micro processing unit (MPU), an application specific integrated circuit (ASIC), or a programmable logic device (PLD), can be used. The control section 15 includes a storage part (not illustrated) such as a read only memory (ROM) or a random access memory (RAM). In the storage part, various control programs and various pieces of data are stored. The control section 15 integrally controls the generating section 11, the modulating section 12, the detecting section 16 (described later), and the signal processing section 17.

The detecting section (imaging device) 16 includes an imaging element such as a charge coupled device (CCD) or a complementary metal oxide semiconductor (CMOS), and receives the target light and the background light. The imaging element converts, for each pixel, the received fluorescence into an electric signal. The detecting section 16 transmits, to the signal processing section 17, electric signals obtained by the conversion.

The signal processing section 17 processes the electric signals received from the detecting section 16, and identifies the target light and the background light. Specifically, the signal processing section 17 distinguishes, for each pixel, a pattern of changes in the electric signal which pattern of changes corresponds to the fluorescence intensity of the target light. The signal processing section 17 then extracts pixels indicating the same pattern of changes as a pattern of changes in the intensity of the pulsed laser light which intensity is modulated by the modulating section 12. The signal processing section 17 may generate and output an image of the extracted pixels. The image generated by the signal processing section 17 is outputted to and displayed on a display provided to the fluorescence detection device 1 or an external display.

The pattern of changes in the electric signal will be described in more detail. In a case where the pulsed laser light is modulated so that the target light is changed, the intensity of the target light changes in synchronization with the modulation. The pattern of changes in the electric signal includes a pattern of change widths of intensity and a phase pattern of changes. The change widths of the intensity correspond to the change widths of the frequency of the pulsed laser light. The phase pattern of changes corresponds to a pattern of ejection of the pulsed laser light. That is, a signal captured in a pixel in which a pattern of changes in the intensity of the signal synchronizes with such a pattern of changes is the electric signal generated by the target light. Therefore, by extracting such a signal, it is possible to extract and identify the target light.

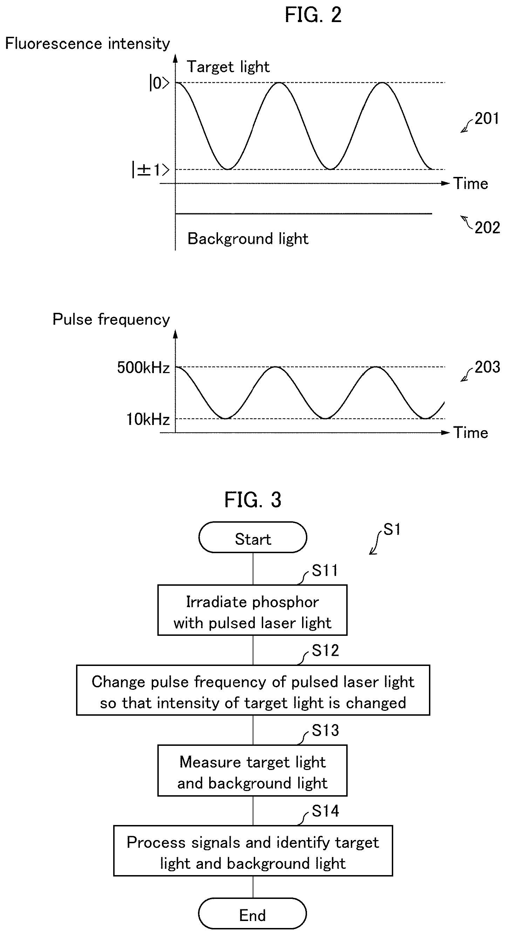

Fig. 2 illustrates a relationship between the pulse frequency of the pulsed laser light and the intensity of the target light. 203 of Fig. 2 shows a pattern of changes in the pulse frequency of the pulsed laser light, and 201 of Fig. 2 shows a pattern of changes in the intensity of the target light. As shown in Fig. 2, the pattern of changes in the intensity of the target light synchronizes with the pattern of changes in the pulse frequency of the pulsed laser light.

Meanwhile, as shown in 202 of Fig. 2, the intensity of the background light is constant, regardless of the changes in the pulse frequency. This is because, in a case where the number of ejections of the pulsed laser light at each data point is constant, an energy state of electrons of a substance that generates the background light does not change by the pulse frequency of the pulsed laser light. Therefore, it is possible to detect and identify only the target light that is a measurement target, by locking in and extracting, by signal processing, only fluorescence that synchronizes with the pattern of changes in the pulse frequency of the pulsed laser light.

In a case where the phosphor 100 is irradiated with excitation light, not only the target light is emitted from the phosphor 100, but also fluorescence is emitted as the background light from a surrounding object. In a case where the target light and the background light are imaged as they are and in a case where the wavelengths of the target light and the background light are close to each other, it is not possible to distinguish between the target light and the background light. However, the fluorescence detection device 1 in accordance with the present embodiment includes the generating section 11 that generates the pulsed laser light and the modulating section 12 that modulates the pulse frequency of the pulsed laser light. This makes it possible to separate the target light from the background light and detect the target light.

Moreover, the generating section 11 and the modulating section 12 used in the present embodiment are simple in configuration, as compared with a device that is used in the conventional technique and that generates a high-frequency magnetic field (a radio wave, a microwave, or the like) or a magnetic field. Therefore, an effect that it is possible to provide a technique of identifying fluorescence emitted from a measurement target with a simpler device configuration as compared with the conventional technique.

### (Fluorescence detection method)

Next, a fluorescence detection method will be described. Fig. 3 is a flowchart illustrating a flow of a fluorescence detection method S1 in accordance with the present embodiment. As illustrated in Fig. 3, the fluorescence detection method S1 includes, as an example, steps S11 through S14. First, in the step S11, the fluorescence detection device 1 irradiates the phosphor 100 with pulsed laser light so that the phosphor 100 emits fluorescence. Next, in the step S12, the pulse frequency of the pulsed laser light is changed so that the intensity of target light (the fluorescence emitted from the phosphor 100) is changed. Next, in the step S13, fluorescence including background light is measured. Next, in the step S14, signals corresponding to the measured fluorescence are processed, and the target light and the background light are identified.

The fluorescence detection method S1 in accordance with the present embodiment brings about an effect that it is possible to provide a technique of identifying fluorescence emitted from a measurement target with a simpler device configuration as compared with the conventional technique.

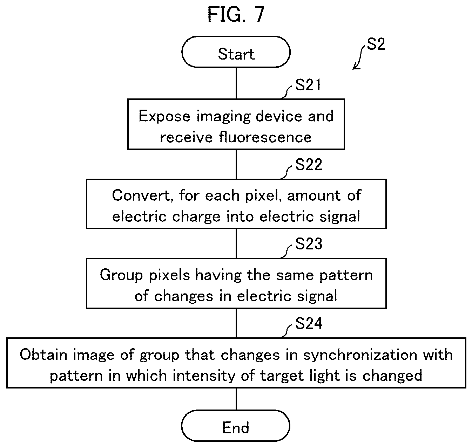

Next, an example of a method of measuring fluorescence and identifying target light and background light will be described. Fig. 7 is a flowchart illustrating a flow of a fluorescence identification method S2. As illustrated in Fig. 7, the fluorescence identification method S2 includes, as an example, steps S21 through S24. First, in the step S21, the fluorescence detection device 1 exposes the imaging device 16 and receives fluorescence. Next, in the step S22, the fluorescence detection device 1 converts, for each pixel, the amount of electric charge into an electric signal. Next, in the step S23, the fluorescence detection device 1 groups pixels having the same pattern of changes in the electric signal. Next, in step S24, the fluorescence detection device 1 obtains an image of a pixel group that changes in synchronization with a pattern in which the intensity of target light is changed. The above-described fluorescence identification method S2 makes it possible to identify merely the target light.

Note that the present embodiment has been described while the phosphor containing the NV center of the diamond is taken as an example of the phosphor. However, the phosphor that can be applied in the present embodiment is not limited to this phosphor. For example, the phosphor may be, other than the NV center of the diamond, an SiV center which contains a silicon atom that substitutes for a carbon atom and a vacancy defect that is adjacent to the silicon atom, a V_{Si}V_{C} center of a silicon carbide crystal which V_{Si}V_{C} center contains a vacancy defect that substitutes for a silicon atom and a vacancy defect that is adjacent to the vacancy defect, or a V_{Si} center of a silicon carbide crystal which V_{Si} center contains a vacancy defect that substitutes for a silicon atom.

### (Measurement of biological sample)

The fluorescence detection device 1 in accordance with the present embodiment can be used to detect a complex of an antibody and a phosphor (an antibody-phosphor complex). This makes it possible to realize highly sensitive detection of an antigen to which the antibody specifically binds.

Further, an interaction that can be detected by the fluorescence detection device 1 is not limited to an antigen-antibody reaction. Examples of the interaction include an interaction between a ligand and a receptor, binding between a ligand and a protein having a binding domain, and a specific interaction between complementary strands in a nucleic acid and a nucleic acid-like low molecular weight compound. Further, it is possible to highly sensitively detect a protein-protein interaction, a protein-peptide interaction, a protein-low molecular weight compound interaction, a specific covalent binding reaction between proteins each having a sequence that covalently binds to a specific peptide sequence, each of which is conventionally known.

A detection target of the antibody is not particularly limited, and only needs to be an antigen to which the antibody specifically binds. Examples of the detection target include peptides, proteins, nucleic acids (such as DNA and RNA), sugars, and lipids. As the antibody, any of polyclonal antibodies, monoclonal antibodies, and fragments thereof (e.g., Fab, F(ab)2, and the like) can be used. Further, the class and the subclass of an immunoglobulin is not particularly limited. The antibody may be one that is selected from an antibody library by a phage display method or the like, or can be a conventionally-known antibody.

The kinds of ligands are not particularly limited, and examples of the ligands include, but are not limited to, proteins, peptides, amino acids, metal ions, low molecular weight substances, organic compounds, inorganic compounds, polysaccharides, nucleic acids, and lipids.

The fluorescence detection device 1 can also be used to detect a specific substance in a sample collected from a living body.

Examples of the sample collected from the living body include blood samples and spinal fluid (cerebrospinal fluid). The blood samples include whole blood, blood plasma, and blood serum. The blood samples are preferably blood plasma or blood serum, and more preferably blood plasma. Blood plasma can be separated from whole blood collected with a heparin salt (preferably sodium salt), a citrate (preferably sodium salt), or an ethylenediamine tetraacetic acid (EDTA) salt (preferably sodium salt or potassium salt). Blood plasma is more preferably blood plasma separated from whole blood collected with an EDTA salt or a heparin salt. The sample is not limited to these examples, provided that the sample is a living body-derived sample such as urine, perspiration, tears, cells, or tissue. A cell culture solution of a living body-derived cell, a cultured cell strain, or the like can also be the sample.

Examples of the living body include mammals, birds, reptiles, and amphibians. Among others, the mammals are preferable. Examples of the mammals include humans and non-human animals. The humans are preferable. Examples of the non-human animals include: domestic animals such as cattle, horses, pigs, and sheep; and pet animals and laboratory animals such as dogs, cats, rats, mice, hamsters, monkeys, and rabbits. Examples of the birds include poultry such as chickens, wild ducks, and domestic ducks.

Examples of the specific substance in the biological sample include: disease biomarkers that are known to be useful in identifying diseases; specific nucleic acid sequences; specific peptide sequences; and specific amino acid sequences. However, the specific substance is not limited to these examples.

The fluorescence detection device 1 can also be used for in vitro test and diagnosis of a target disease, by using a disease biomarker as a detection target.

Alternatively, the fluorescence detection device 1 can be used for in vitro test and diagnosis of a virus infection or the like by using, as a detection target, an antigen such as a nucleic acid sequence or the like derived from a virus, bacteria, or a microorganism.

Alternatively, it is also possible to detect a specific substance in a sample collected from an object other than a living body. For example, the fluorescence detection device 1 can be used for an environmental microorganism test by using, as a detection target, a microorganism or the like collected from an environment, food, water, soil, or the like.

The fluorescence detection device 1 can be used as an in vitro diagnostic device, and the fluorescence detection method can be used as an in vitro diagnostic method.

The fluorescence detection device 1 is capable of detecting a fluorescence-labeled nucleic acid. It is possible to detect amplification of a nucleic acid by detecting the amount of fluorescence incorporated in a complementary strand of the nucleic acid (DNA, RNA, or the like).

The fluorescence detection device 1 can be used as a nucleic acid amplification detection device, and the fluorescence detection method can be used as a nucleic acid amplification detection method.

### Embodiment 2

The following description will discuss another embodiment of the present invention. Note that, for convenience, members having the same functions as those of the members described in the above embodiment are given respective identical reference numerals, and descriptions of those members are omitted. In the present embodiment, an example will be described in which the intensity of background light is also changed.

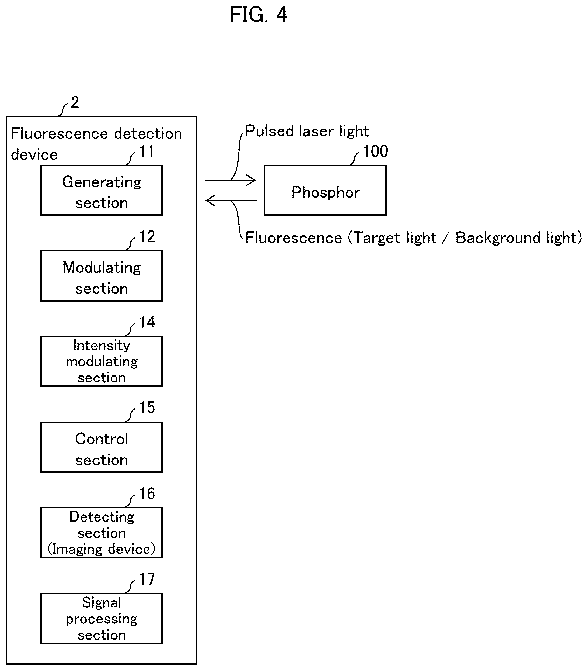

Fig. 4 is a block diagram illustrating a configuration of a fluorescence detection device 2 in accordance with Embodiment 2 of the present invention. As illustrated in Fig. 4, the fluorescence detection device 2 includes a generating section 11, a modulating section 12, an intensity modulating section 14, a control section 15, a detecting section 16, and a signal processing section 17. Note that the control section 15, the detecting section 16, and the signal processing section 17 are as described in Embodiment 1 and, therefore, descriptions thereof are omitted here.

The generating section 11 generates pulsed laser light which causes spin polarization and spin relaxation in a phosphor that emits fluorescence whose intensity varies according to magnetic resonance. The modulating section 12 modulates the pulse frequency of the pulsed laser light with use of a carrier wave having a first frequency and a first phase. The intensity modulating section 14 modulates the intensity (amplitude) of the pulsed laser light with use of a carrier wave having a second frequency differing from the first frequency and/or a second phase differing from the first phase.

The modulating section 12 may be a first signal generating section that generates a signal for controlling the generating section 11 so that the generating section 11 pulse-oscillates a laser having a pulse frequency of the first frequency and the first phase. The intensity modulating section 14 may be a second signal generating section that generates a signal for controlling the generating section 11 so that the generating section 11 oscillates laser light having intensity of the second frequency and/or the second phase. The fluorescence detection device 2 irradiates a phosphor 100 with the pulsed laser light whose frequency and intensity are modulated.

In the present embodiment, the intensity of target light changes by the modulating section 12 modulating the pulse frequency. Meanwhile, the intensity of the background light changes by the intensity modulating section 14 modulating the intensity. Therefore, it is possible to identify, as the target light, fluorescence whose intensity changes in synchronization with a pattern of modulation of the pulse frequency which modulation is carried out by the modulating section 12, and identify, as the background light, fluorescence whose intensity changes in synchronization with a pattern of modulation of the intensity which modulation is carried out by the intensity modulating section 14.

Note that, in the above embodiment, the generating section 11 has been described as including a single laser oscillator that generates the pulsed laser light. However, the generating section 11 may include two laser oscillators (not illustrated). In this case, one of the laser oscillators is a laser oscillator for changing the intensity of fluorescence emitted from an NV center, and laser light therefrom is modulated by the modulating section 12. The other of the laser oscillators is a laser oscillator for changing the intensity of the background light, and laser light therefrom is modulated by the intensity modulating section 14.

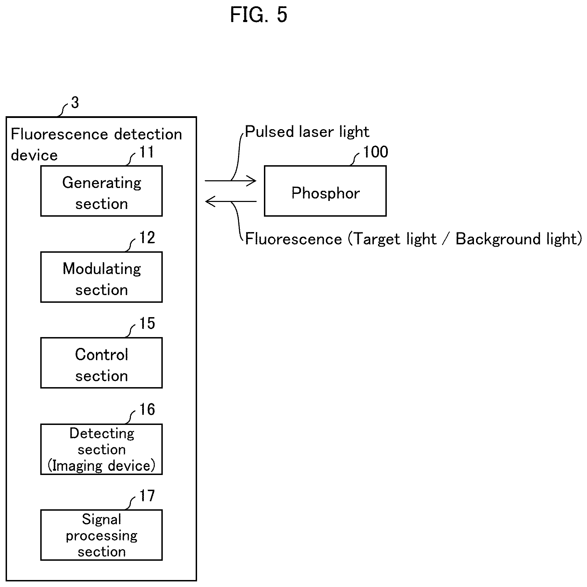

Further, as illustrated in Fig. 5, a similar result is obtained also in a configuration in which the modulating section 12 also functions as the intensity modulating section 14. Fig. 5 is a block diagram of a fluorescence detection device 3 including a modulating section 12 that also has a function of an intensity modulating section 14. In the fluorescence detection device 3, the modulating section 12 modulates the pulse frequency and the intensity of a laser generated by the generating section 11 in parallel.

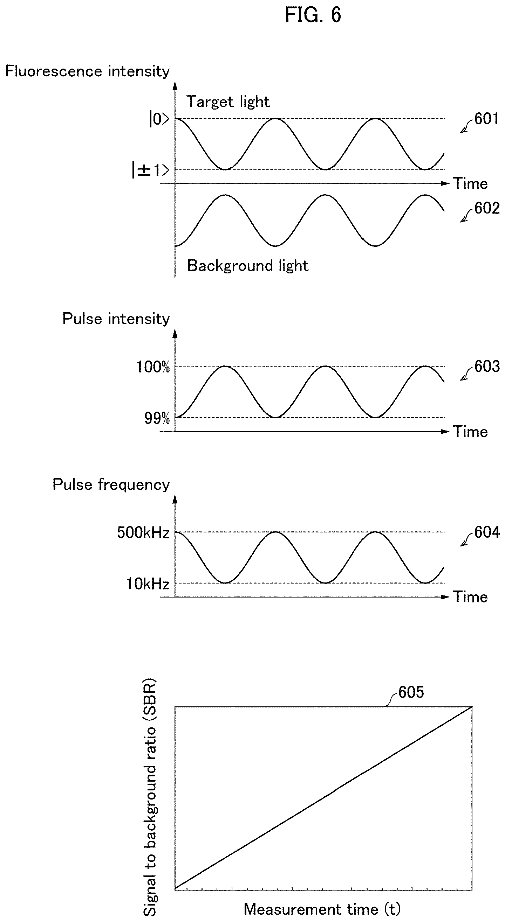

Fig. 6 illustrates (i) a relationship between the pulse frequency of the pulsed laser light that changes the target light and the intensity of the target light and (ii) a relationship between the pulse intensity of the pulsed laser light that changes the background light and the intensity of the background light. Specifically, 603 of Fig. 6 shows a pattern of changes in the pulse intensity of the pulsed laser light, and 604 of Fig. 6 shows a pattern of changes in the pulse frequency of the pulsed laser light. As is clear from these, a phase of changes in the pulse intensity and a phase of changes in the pulse frequency are shifted 180 degrees from each other. Further, 602 of Fig. 6 shows changes in the intensity of the background light, and 601 of Fig. 6 shows changes in the intensity of the target light.

As shown in 601 of Fig. 6, a pattern of changes in the intensity of the target light is shifted 180 degrees from a pattern of changes in the intensity of the background light. It is found from this fact that fluorescence having a pattern of changes in intensity which pattern synchronizes with the pattern of changes in the pulse intensity of the pulsed laser light is the background light and that fluorescence having a pattern of changes in intensity which pattern synchronizes with the pattern of changes in the pulse frequency of the pulsed laser light is the target light. The signal processing section 17 is capable of extracting the target light and the background light separately, by locking in signals having such synchronizing patterns of changes. Note that the amount of the shift between the phase of changes in the pulse intensity and the phase of changes in the pulse frequency does not need to be 180 degrees. However, in a case where the first frequency and the second frequency are the same, 180 degrees is an optimum condition, and, conversely, it is not preferable that the amount of the shift be +90 degrees or -90 degrees. Otherwise, the amount of the shift is not particularly limited. For example, it is particularly preferable that the amount of the shift be 180 degrees±45 degrees.

Note that, in an example shown in 604 of Fig. 6, the pulse frequency is changed between 10 kHz and 500 kHz. However, a modulation range of the pulse frequency is not limited to this example. For example, the modulation range of the pulse frequency may be a range between 100 Hz and 200 MHz, preferably a range between 1 kHz and 1000 kHz, and more preferably a range between 10 kHz and 500 kHz. By modulating the pulse frequency in such a range, it is possible to carry out measurement with improved accuracy. In a case where the modulated pulse frequency falls below 100 Hz, a measurement time becomes long and time resolution decreases. Therefore, this is not preferable.

Note that the modulation amplitude of the background light is smaller than the modulation amplitude of the fluorescence from the phosphor, the modulation amplitude of the background light being a change in the intensity of the background light which change is caused by the intensity modulating section 14 modulating the intensity, the modulation amplitude of the fluorescence from the phosphor being a change in the intensity of the fluorescence from the phosphor which change is caused by the modulating section 12 modulating the pulse frequency. This makes it possible to detect modulation of the intensity of the target light even in a case where modulation of the intensity of the background light occurs. Note, here, that the modulation amplitude of the background light is a difference between the maximum value and the minimum value of the change in the intensity of the background light shown in 602 of Fig. 6. Note also that the modulation amplitude of the fluorescence is a difference between the maximum value and the minimum value of the change in the intensity of the target light shown in 601 of Fig. 6.

In an example shown in 603 of Fig. 6, the pulse intensity of the pulsed laser light is changed so that the background light oscillates between 99% and 100% of the modulation amplitude of the fluorescence. That is, the pulse intensity is changed so that the intensity of the background light to be measured oscillates between 99% and 100% of the modulation amplitude of the fluorescence. At this time, the modulation amplitude of the background light is said to be 1%. This modulation amplitude of the background light does not need to be 1%, and only needs to be not more than 5%. The lower limit of the modulation amplitude of the background light may be approximately 0.01% or may be even lower. In a case where the lower limit exceeds 5%, an effect is reduced.

As has been described, in the present embodiment, not only the intensity of target light but also the intensity of background light is changed. Therefore, it is possible to use the background light as information for identifying the background light. That is, measurement accuracy is improved by processing data including not only the target light but also the background light. Specifically, a signal to background ratio (SBR) obtained by measurement in the present embodiment is in proportion to a measurement time (t). In contrast, in the conventional technique in which only the target light (signal) is processed, the SBR is in proportion only to the square root of the measurement time (t) because there is no information about the background light (background). That is, it is meant that, in the measurement by the present embodiment, a higher SBR is obtained (detection accuracy is improved) in the same measurement time than in the conventional technique.

Note that, in the above embodiment, the frequency with which the pulse intensity is modulated is the same as the frequency with which the pulse frequency is modulated. However, the frequency with which the pulse intensity is modulated may differ from the frequency with which the pulse frequency is modulated. By identifying fluorescence having intensity that changes in synchronization with each of these frequencies, it is possible to identify the target light and the background light. Note, however, that a condition under the first frequency becomes the second frequency multiplied by an integer of 2 or more or a condition under which the second frequency becomes the first frequency multiplied by an integer of 2 or more should be avoided. Under the other conditions, the frequency with which the pulse intensity is modulated and the frequency with which the pulse frequency is modulated may be made different from each other, as appropriate.

As has been described, included are the generating section 11 that generates pulsed laser light, the modulating section 12 that modulates the pulse frequency of the pulsed laser light with use of a carrier wave having a first frequency and a first phase, and the intensity modulating section 14 that modulates the intensity of the pulsed laser light with use of a carrier wave having a second frequency differing from the first frequency and/or a second phase differing from the first phase. Thus, with a simple configuration of a laser oscillator and a modulating device, it is possible to identify and extract target light and background light. Moreover, by processing data including not only the target light but also the background light, an effect that it is possible to improve measurement accuracy is brought about.

### (Modifications)

Note that, in the above embodiment, an example has been described in which the pulsed laser light is used as excitation light. However, the excitation light is not limited to pulsed light, and may be continuous light. Further, in the above embodiment, an example has been described in which the intensity is modulated by changing the pulse frequency. However, the above embodiment is not limited to this example, and the intensity may be modulated by changing the pulse amplitude.

The present invention is not limited to the embodiments, but can be altered by a skilled person in the art within the scope of the claims. The present invention also encompasses, in its technical scope, any embodiment derived by combining technical means disclosed in differing embodiments.

### [Example 1]

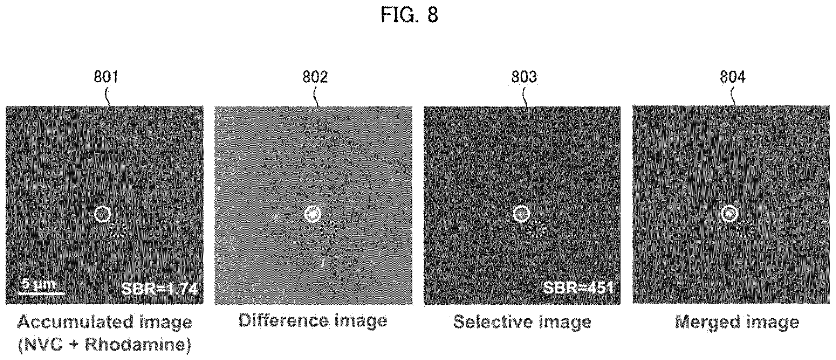

Example 1 of the present invention will be described below with reference to Figs. 8 to 13. A demonstration experiment was carried out by applying the present technique to an in vitro sample that had been obtained by adsorbing fluorescent nanodiamonds on a coverslip stained with rhodamine-phalloidin (hereinafter referred to as rhodamine). Rhodamine is generally used for intracellular labeling of cytoskeletal actin. Rhodamine emits fluorescence in a wavelength range of 550 nm to 700 nm after being excited by green light. Therefore, even under a measurement condition at a time when a fluorescent nanodiamond is observed, intense fluorescence from rhodamine is observed (a part of 801 of Fig. 8 which part is enclosed by a dotted-line circle, a part which is enclosed by a solid-line circle indicates fluorescence from an NV center).

With use of a CCD camera, exposure was carried out for 100 ms per frame. The exposure and irradiation with pulsed laser light were synchronized such that, during the exposure, irradiation with the pulsed laser light was carried out at 950 pulses/frame and at ejection intervals of 100 µs in each odd-numbered frame and at ejection intervals of 2 µs in each even-numbered frame. The total irradiation intensity in the even-numbered frames was approximately 99% of the total irradiation intensity in the odd-numbered frames.

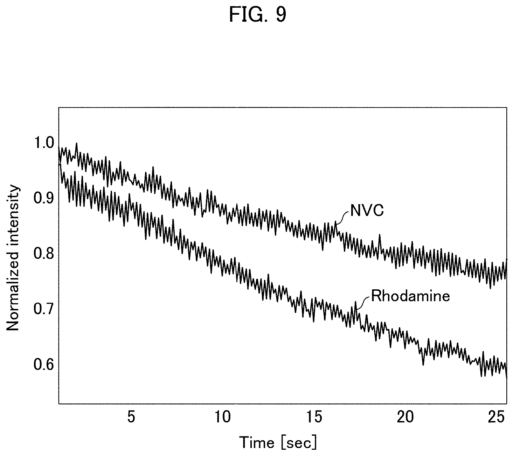

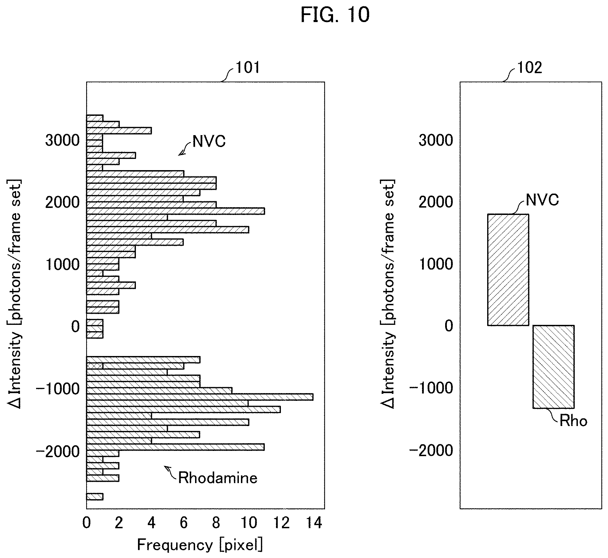

As a result, fluorescence intensity derived from NVCs and fluorescence intensity derived from the rhodamine varied in the same period and in opposite phase (Fig. 9). A difference image obtained from the even-numbered frame and the odd-numbered frame (802 in Fig. 8) showed a differential intensity distribution similar to that in a simulation (101 of Fig. 10). A difference between a distribution attributed to the NVCs and a distribution attributed to the rhodamine was statistically significant (102 of Fig. 10). By thresholding the difference image at 0, fluorescence from the rhodamine was eliminated, and a selective image of the fluorescent nanodiamonds was obtained (803 of Fig. 8). Note that it was confirmed, also by ODMR frequency spectra, that these bright spots indicated the fluorescent nanodiamonds.

Furthermore, typical signal to background ratios (SBRs) obtained in the experiment were evaluated by comparing fluorescence intensity derived from a fluorescent nanodiamond with fluorescence intensity derived from a rhodamine background (solid-line circles and dotted-line circles in 801 to 804 of Fig. 8). The SBR of an accumulated image made up of 256 frames was 1.74 (801 of Fig. 8), whereas the SBR of the selective image obtained from the same image set was improved to 451 (803 of Fig. 8).

### [Example 2]

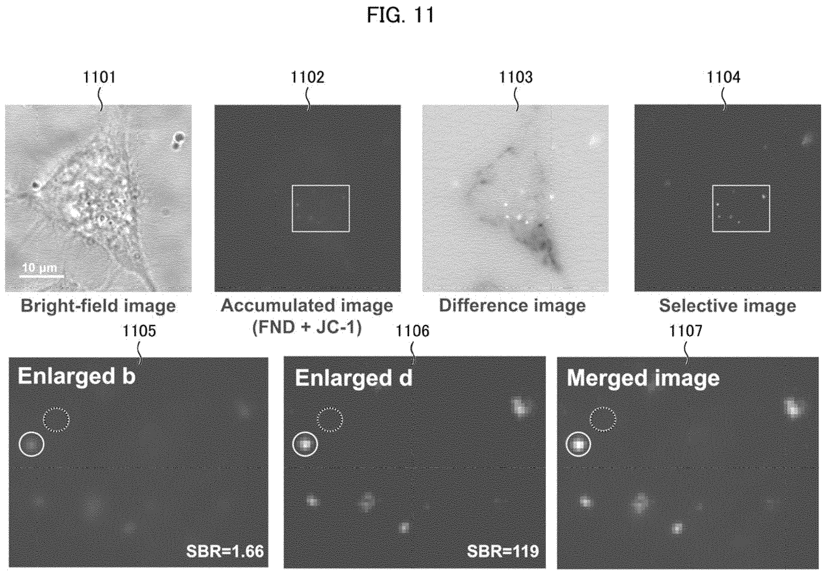

Example 2 of the present invention will be described below. Example 2 shows a result of an experiment in which a cultured cell was used. The biological applicability of the present technique was verified by obtaining a selective image of fluorescent nanodiamonds that had been introduced into a living cell stained with a fluorescent dye (Fig. 11).

The fluorescent nanodiamonds were introduced into a HeLa cell (1101 of Fig. 11) by endocytosis. The HeLa cell was stained with a JC-1 fluorescent dye. Then, the present technique was applied. JC-1 is widely used to detect a mitochondrial membrane potential that is an index of a mitochondrial health state associated with apoptosis and necrosis. Mitochondria, on the other hand, have recently become important measurement targets in quantum sensing in which NVCs are used. However, a hem of a fluorescence emission spectrum (λₑₘ=590) of JC-1 slightly overlaps with a hem of an NVC. Background light caused by this overlapping of the spectra adversely affects detection of a fluorescent nanodiamond in fluorescence imaging (1102 of Fig. 11).

However, it was found that, by using the present technique, a clearer selective image of a fluorescent nanodiamond in a living cell was obtained (1103 and 1104 of Fig. 11). Typical SBRs were evaluated between (i) a fluorescent nanodiamond indicated by a solid-line circle in 1105 of Fig. 11 and (ii) a JC-1 background indicated by a dotted-line circle in 1105 of Fig. 11. The SBRs of an accumulated image and the selective image each obtained from 256 frames (1102 and 1103 of Fig. 11) were respectively 1.66 and 119 (1105 and 1106 of Fig. 11). By applying the present technique, background light (derived from JC-1) was eliminated also in the living cell, and also the SBR was improved not less than 50 times.

### [Example 3]

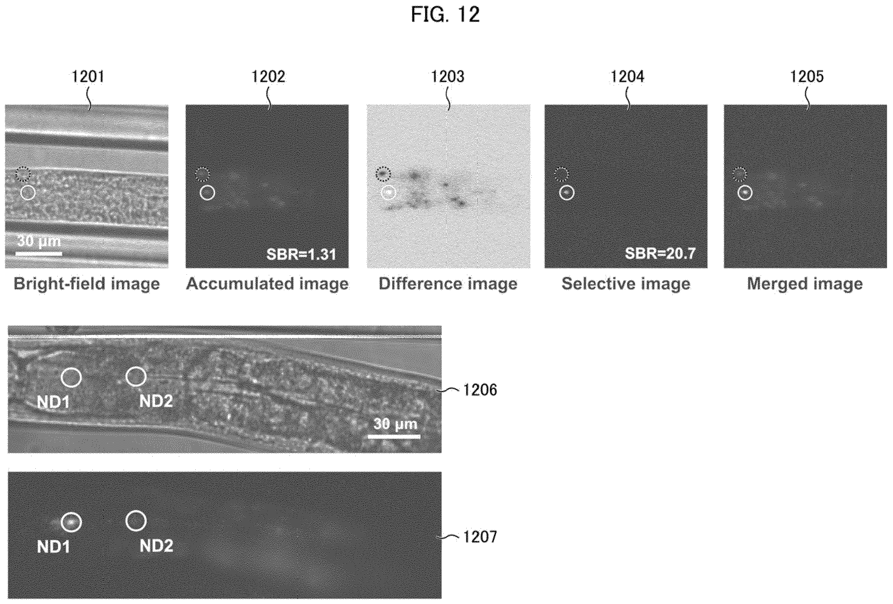

Example 3 of the present invention will be described below. Biological samples often exhibit particulate autofluorescence caused by intrinsic and extrinsic fluorescent granules. Therefore, the present method is particularly useful in quantitative measurement of an in vivo microenvironment in which measurement a nanodiamond is used as a quantum sensor. For example, *C. elegans* (1201 of Fig. 12) emits intense red particulate autofluorescence, which is referred to as "age pigment" (1202 of Fig. 12). The presence of such particulate autofluorescence makes it extremely difficult to locate a fluorescent nanodiamond that has been introduced into *C*. *elegans* in an attempt to, for example, measure a temperature.

However, when the present method was used, it was possible to easily distinguish between fluorescent nanodiamonds and particulate autofluorescence (1203 to 1205 and 1207 of Fig. 12). Typical SBRs were evaluated between (i) a fluorescent nanodiamond indicated by solid-line circles in 1201 to 1205 of Fig. 12 and (ii) particulate autofluorescence indicated by dotted-line circles in 1201 to 1205 of Fig. 12. The SBRs of an accumulated image and a selective image each made up of 256 frames were respectively 1.31 and 20.7 (1202 and 1204 of Fig. 12).

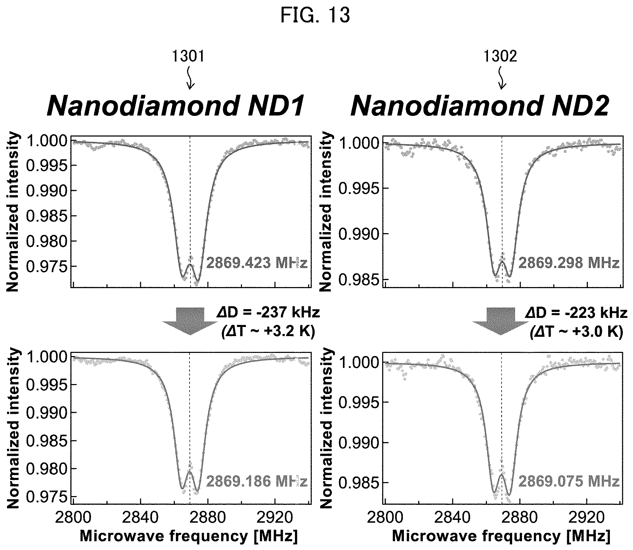

In addition, changes in the temperature of living *C*. *elegans* were also measured with use of fluorescent nanodiamonds that had been located by the present technique. In order to change the temperature of the sample, a heater was placed close to the *C. elegans* sample. With use of ODMR of two fluorescent nanodiamonds that existed relatively close to each other (ND1 and ND2; 1206 and 1207 of Fig. 12), changes in the temperatures of ND1 and ND2 between before and after external heating were simultaneously evaluated. Zero-field splitting widths D obtained by ODMR frequency spectra changed as the temperature of the sample increased (Fig. 13). As shown in 1301 and 1302 of Fig. 13, changes in D in ND1 and ND2 were respectively -237±96 kHz and -223±144 kHz, which respectively corresponded to changes in the temperatures of 3.2±1.3 K and 3.0±1.9 K. As expected, values of changes in two temperatures were relatively similar.

In conventional in vivo measurement in which a fluorescence nanodiamond is used as a quantitative sensor, it is difficult to find the nanodiamond buried in autofluorescence. Thus, much time has been spent. The newly proposed present technique will be a powerful tool in bio-application of a fluorescent nanodiamond.

### [Example 4]

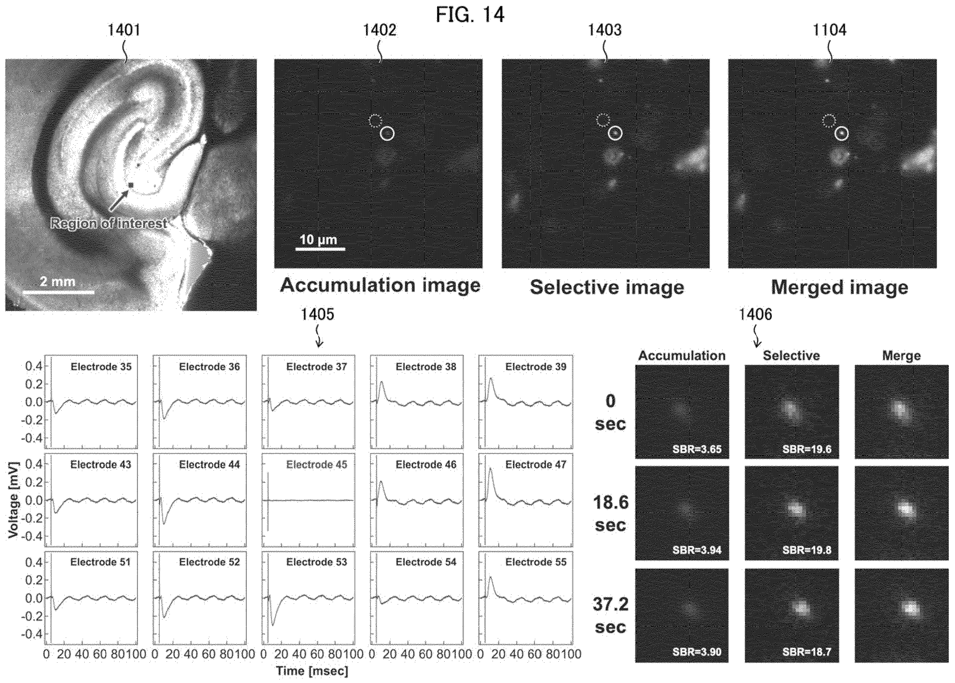

Example 4 of the present invention will be described below. In Example 4, it was demonstrated that the present technique was effective also for a sample of a higher eukaryote, by observing fluorescence nanodiamonds on an ex vivo hippocampus slice obtained from a rat (1401 of Fig. 14).

Before the observation, it was confirmed, with use of a microelectrode array system, that potentials were evoked after electrical stimulation, in order to prove that this hippocampus slice sample was alive. As a result, evoked potentials shown in 1405 of Fig. 14 were observed at a position of a region of interest (a rectangle ahead of an arrow) shown in 1401 of Fig. 14. When the fluorescent nanodiamonds were observed at this position, images with a lower background and higher contrast than those of an accumulated image (1402 of Fig. 14) were obtained by the present technique (1403 and 1404 of Fig. 14), though the hippocampus slice that had been washed well showed extremely low autofluorescence.

In addition, the selective image was reconstructed as a moving image by creating moving average images by sliding window of 64 frames to 256 frames (1406 of Fig. 14). As a result, translational motions similar to those seen in a moving image of the accumulated image which moving image was created by similar sliding window were observed with a lower background. SBRs were evaluated. As a result, the SBR of the accumulated image in which 256 frames were used was an average of 3.90, whereas the SBR of the selective image in which the same 256 frames were used was an average of 19.3 (1406 of Fig. 14).

A neural circuit of a brain is an important measurement target for an NVC. A cultured hippocampus of a rat is one of the simplest and most controllable experimental model systems for neural circuits in the brains of mammals. Potentials evoked after electrical stimulation, as shown in 1405 of Fig. 14, are generally used for measurement of a neural circuit. However, this method, which relies solely on potentials, is limited only to neural activities in which information to be obtained relates to potentials. Therefore, desired are experimental techniques which provide information about physical and chemical parameters relating to brain cells including glia cells. In particular, the importance of a relationship between a brain function and the pH of a microenvironment begins to attract attention. In recent years, a fluorescent nanodiamond is also expanding its application range also to measurement of not only a temperature and a magnetic field but also a pH. It is considered that measurement of the physical and chemical parameters of a neural circuit of a brain can be carried out with use of a fluorescent nanodiamond. In particular, it is considered that the present technique demonstrates its performance in a case where a recombinant mouse in which a fluorescent protein is expressed is used.

### [Example 5]

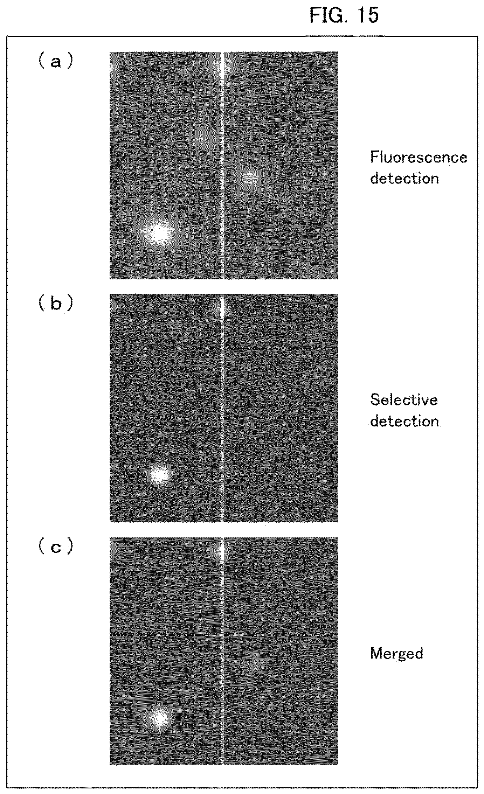

Example 5 of the present invention will be described below with reference to Fig. 15. Fluorescent nanodiamonds were each modified with an antibody of phosphorylated tau protein (pTau), and the antibody and pTau were bound. Thereafter, the nanodiamonds each modified with the antibody to which the pTau was bound were bound to an antibody of tau protein (Tau) which antibody was immobilized on a glass substrate, and then fluorescence generated by excitation was imaged.

A method of generating the fluorescence was as follows. The fluorescent nanodiamonds were pulse-irradiated with a green laser having a wavelength of 532 nm as an excitation light source. The intensity of the green laser was modulated by adjusting pulse intensity so that the pulse intensity in even-numbered frames was 99% of the pulse intensity in odd-numbered frames. The intensity of the green laser in the odd-numbered frames was set to 100 mW.

Under the above conditions, the fluorescence from the fluorescent nanodiamonds (target light) and fluorescence from an object other than the fluorescent nanodiamonds (background light) were collected with use of a 20x objective lens, and a fluorescence image obtained through a long pass filter that transmitted light having a wavelength of not less than 650 nm was captured as a moving image with use of an electron multiplier type CCD camera. The moving image was captured by capturing 10 frames per second and capturing frames for 100 seconds to obtain 1000 frames.

(a) of Fig. 15 is an accumulated image (fluorescence detection image) of frames which was captured by the above method. In (a) of Fig. 15, the target light and the background light are imaged in the same manner, and thus it is not possible to distinguish between the target light and the background light. (b) of Fig. 15 is a selective image obtained by imaging, in white, only pixels each of which had a pixel difference value greater than zero and which were pixels in a difference image that had been obtained by subtracting, for each pixel, a fluorescence count value of an odd-numbered frame from a fluorescence count value of an even-numbered frame that was adjacent to the odd-numbered frame. In (b) of Fig. 15, only the nanodiamonds modified with the antibody to which the pTau was bound were detected. (c) of Fig. 15 is a merged image obtained by merging the fluorescence detection image and the selective image obtained. Although (c) of Fig. 15 is a black-and-white image and is therefore unclear, it is possible to visually recognize fluorescence as target light by causing the fluorescence present at the same location in the fluorescence detection image and the selective image to be displayed in a different color.

A bright spot visible only in the accumulated image is a bright spot based on the background light, and could be eliminated in the selective image. That is, the bright spot visible in the selective image is the fluorescence derived from the pTau. Tau protein is a substance that causes dementia by abnormally accumulating in a brain. pTau is a biomarker molecule detected by abnormal accumulation thereof. Detecting pTau is important also for diagnosing dementia. By using an antibody-modified nanodiamond as in the present example, it is possible to easily detect phosphorylated tau protein in a body fluid.

### Reference Signs List

- 1, 2, 3: Fluorescence detection device
- 11: Generating section
- 12: Modulating section
- 14: Intensity modulating section
- 15: Control section
- 16: Detecting section
- 17: Signal processing section
- 100: Phosphor

## Claims

1. A fluorescence detection device comprising:
a generating section (11) configured to generate pulsed laser light which causes spin polarization and spin relaxation in a phosphor that emits fluorescence whose intensity varies according to magnetic resonance;
a modulating section configured to modulate a pulse frequency of the pulsed laser light;
an intensity modulating section (14) configured to modulate intensity of the pulsed laser light;
a detecting section (16) including an imaging element for receiving target light and background light, the target light being fluorescence emitted from the phosphor and the background light being fluorescence emitted from an object other than the phosphor, and the detecting section being configured to convert, for each pixel, the received fluorescence into an electric signal; and
a signal processing section (17) for processing the electric signals from the detecting section and identifying the target light and background light,
wherein the modulating section is configured to modulate the pulse frequency of the pulsed laser light with use of a carrier wave having a first frequency and a first phase,
wherein the intensity modulating section is configured to modulate the intensity of the pulsed laser light with use of a carrier wave having a second frequency and a second phase,
wherein the second frequency differs from the first frequency and/or the second phase differs from the first phase,
and wherein the signal processing section (17) is configured to extract the target light and background light separately, in that, for extracting the target light, electric signals having a pattern of changes which synchronizes with a pattern of changes in the pulse frequency of the pulsed laser light are locked in, and for extracting the background light, electric signals having a pattern of changes which synchronizes with a pattern of changes in the intensity of the pulsed laser light are locked in.

2. The fluorescence detection device as set forth in claim 1, wherein the modulating section is configured to modulate the pulse frequency of the pulsed laser light within a range of 100 Hz to 200 MHz.

3. The fluorescence detection device as set forth in any one of claims 1 or 2, wherein the modulating section also functions as the intensity modulating section.

4. The fluorescence detection device as set forth in any one of claims 1 to 3, wherein modulation amplitude of the background light is smaller than modulation amplitude of the target light, the modulation amplitude of the background light being a change in intensity of the background light which change is caused by the intensity modulating section modulating the intensity of the pulsed laser light, and the modulation amplitude of the target light being a change in the intensity of the target light which change is caused by the modulating section modulating the pulse frequency of the pulsed laser light.

5. The fluorescence detection device as set forth in claim 4, wherein the modulation amplitude of the background light caused by the modulating of the intensity of the pulsed laser light by the intensity modulating section is not more than 5%.

6. The fluorescence detection device as set forth in any one of claims 1 to 5, wherein the phosphor contains at least one selected from the group consisting of: an NV center of a diamond which NV center contains a nitrogen atom that substitutes for a carbon atom and a vacancy defect that is adjacent to the nitrogen atom; an SiV center of a diamond which SiV center contains a silicon atom that substitutes for a carbon atom and a vacancy defect that is adjacent to the silicon atom; a V_{Si}V_{C} center of a silicon carbide crystal which V_{Si}V_{C} center contains a vacancy defect that substitutes for a silicon atom and a vacancy defect that is adjacent to the vacancy defect; and a V_{Si} center of a silicon carbide crystal which V_{Si} center contains a vacancy defect that substitutes for a silicon atom.

7. A fluorescence detection method comprising the steps of:
generating, by a generating section, pulsed laser light which causes spin polarization and spin relaxation in a phosphor that emits fluorescence whose intensity varies according to magnetic resonance;
modulating, by a modulating section, a pulse frequency of the pulsed laser light,
modulating, by an intensity modulating section, an intensity of the pulsed laser light,
receiving, by a detecting section including an imaging element, target light and background light, the target light being fluorescence emitted from the phosphor and the background light being fluorescence emitted from an object other than the phosphor, and converting (S22) for each pixel, the received fluorescence into an electric signal; and
processing the electric signals from the detecting section and identifying the target light and background light by a signal processing section,
wherein the modulating section modulates the pulse frequency of the pulsed laser light with use of a carrier wave having a first frequency and a first phase,
wherein the intensity modulating section modulates the intensity of the pulsed laser light with use of a carrier wave having a second frequency and a second phase,
wherein the second frequency differs from the first frequency and/or the second phase differs from the first phase,
and wherein the target light and background light are extracted separately by the signal processing section, in that, for extracting the target light, electric signals having a pattern of changes which synchronizes with a pattern of changes in the pulse frequency of the pulsed laser light are locked in, and for extracting the background light, electric signals having a pattern of changes which synchronizes with a pattern of changes in the intensity of the pulsed laser light are locked in.

## Patentansprüche

1. Fluoreszenzdetektionsvorrichtung, umfassend:
einen Generierungsabschnitt (11), der dazu ausgestaltet ist, gepulstes Laserlicht zu generieren, das Spinpolarisation und Spinrelaxation in einem Leuchtstoff bewirkt, der Fluoreszenz emittiert, deren Intensität gemäß Magnetresonanz variiert;
einen Modulationsabschnitt, der dazu ausgestaltet ist, eine Pulsfrequenz des gepulsten Laserlichts zu modulieren;
einen Intensitätsmodulationsabschnitt (14), der dazu ausgestaltet ist, die Intensität des gepulsten Laserlichts zu modulieren;
einen Detektionsabschnitt (16), der ein Bildgebungselement zum Empfangen von Ziellicht und Hintergrundlicht einschließt, wobei das Ziellicht Fluoreszenz ist, die von dem Leuchtstoff emittiert wird, und das Hintergrundlicht Fluoreszenz ist, die von einem anderen Objekt als dem Leuchtstoff emittiert wird, und wobei der Detektionsabschnitt dazu ausgestaltet ist, für jedes Pixel die empfangene Fluoreszenz in ein elektrisches Signal umzuwandeln; und
einen Signalverarbeitungsabschnitt (17) zum Verarbeiten der elektrischen Signale von dem Detektionsabschnitt und Identifizieren des Ziellichts und Hintergrundlichts,
wobei der Modulationsabschnitt dazu ausgestaltet ist, die Pulsfrequenz des gepulsten Laserlichts unter Verwendung einer Trägerwelle mit einer ersten Frequenz und einer ersten Phase zu modulieren,
wobei der Intensitätsmodulationsabschnitt dazu ausgestaltet ist, die Intensität des gepulsten Laserlichts unter Verwendung einer Trägerwelle mit einer zweiten Frequenz und einer zweiten Phase zu modulieren,
wobei sich die zweite Frequenz von der ersten Frequenz unterscheidet und/oder sich die zweite Phase von der ersten Phase unterscheidet, und wobei der Signalverarbeitungsabschnitt (17) dazu ausgestaltet ist,
das Ziellicht und Hintergrundlicht separat zu extrahieren, indem zum Extrahieren des Ziellichts elektrische Signale mit einem Muster von Änderungen, das mit einem Muster von Änderungen der Pulsfrequenz des gepulsten Laserlichts synchronisiert ist, verriegelt werden und zur Extraktion des Hintergrundlichts elektrische Signale mit einem Muster von Änderungen, das mit einem Muster von Änderungen der Intensität des gepulsten Laserlichts synchronisiert ist, verriegelt werden.

2. Fluoreszenzdetektionsvorrichtung nach Anspruch 1, wobei der Modulationsabschnitt dazu ausgestaltet ist, die Pulsfrequenz des gepulsten Laserlichts innerhalb eines Bereichs von 100 Hz bis 200 MHz zu modulieren.

3. Fluoreszenzdetektionsvorrichtung nach einem der Ansprüche 1 oder 2, wobei der Modulationsabschnitt auch als der Intensitätsmodulationsabschnitt fungiert.

4. Fluoreszenzdetektionsvorrichtung nach einem der Ansprüche 1 bis 3, wobei die Modulationsamplitude des Hintergrundlichts kleiner als die Modulationsamplitude des Ziellichts ist, wobei die Modulationsamplitude des Hintergrundlichts eine Änderung der Intensität des Hintergrundlichts ist, wobei die Änderung durch den Intensitätsmodulationsabschnitt bewirkt wird, der die Intensität des gepulsten Laserlichts moduliert, und wobei die Modulationsamplitude des Ziellichts eine Änderung der Intensität des Ziellichts ist, wobei die Änderung durch den Modulationsabschnitt bewirkt wird, der die Pulsfrequenz des gepulsten Laserlichts moduliert.

5. Fluoreszenzdetektionsvorrichtung nach Anspruch 4, wobei die Modulationsamplitude des Hintergrundlichts, die durch das Modulieren der Intensität des gepulsten Laserlichts durch den Intensitätsmodulationsabschnitt bewirkt wird, nicht mehr als 5 % beträgt.

6. Fluoreszenzdetektionsvorrichtung nach einem der Ansprüche 1 bis 5, wobei der Leuchtstoff mindestens eines ausgewählt aus der Gruppe bestehend aus Folgendem enthält: einem NV-Zentrum eines Diamanten, dessen NV-Zentrum ein Stickstoffatom, das ein Kohlenstoffatom ersetzt, und einen Leerstellendefekt enthält, der benachbart zu dem Stickstoffatom ist; einem SiV-Zentrum eines Diamanten, dessen SiV-Zentrum ein Siliciumatom, das ein Kohlenstoffatom ersetzt, und einen Leerstellendefekt enthält, der benachbart zu dem Siliciumatom ist; einem V_{Si}V_{C}-Zentrum eines Siliciumcarbidkristalls, dessen V_{Si}V_{C}-Zentrum einen Leerstellendefekt, der ein Siliciumatom ersetzt, und einen Leerstellendefekt enthält, der benachbart zu dem Leerstellendefekt ist; und einem V_{Si}-Zentrum eines Siliciumcarbidkristalls, wobei das V_{Si}-Zentrum einen Leerstellendefekt enthält, der ein Siliciumatom ersetzt.

7. Fluoreszenzdetektionsverfahren, umfassend die Schritte:
Generieren von gepulstem Laserlicht, das Spinpolarisation und Spinrelaxation in einem Leuchtstoff bewirkt, der Fluoreszenz emittiert, deren Intensität gemäß Magnetresonanz variiert, durch einen Generierungsabschnitt;
Modulieren einer Pulsfrequenz des gepulsten Laserlichts durch einen Modulationsabschnitt,
Modulieren einer Intensität des gepulsten Laserlichts durch einen Intensitätsmodulationsabschnitt,
Empfangen von Ziellicht und Hintergrundlicht durch einen Detektionsabschnitt, der ein Bildgebungselement einschließt, wobei das Ziellicht Fluoreszenz ist, die von dem Leuchtstoff emittiert wird, und das Hintergrundlicht Fluoreszenz ist, die von einem anderen Objekt als dem Leuchtstoff emittiert wird, und Umwandeln (S22) der empfangenen Fluoreszenz in ein elektrisches Signal für jedes Pixel; und
Verarbeiten der elektrischen Signale von dem Detektionsabschnitt und Identifizieren des Ziellichts und Hintergrundlichts durch einen Signalverarbeitungsabschnitt,
wobei der Modulationsabschnitt die Pulsfrequenz des gepulsten Laserlichts unter Verwendung einer Trägerwelle mit einer ersten Frequenz und einer ersten Phase moduliert,
wobei der Intensitätsmodulationsabschnitt die Intensität des gepulsten Laserlichts unter Verwendung einer Trägerwelle mit einer zweiten Frequenz und einer zweiten Phase moduliert,
wobei sich die zweite Frequenz von der ersten Frequenz unterscheidet und/oder sich die zweite Phase von der ersten Phase unterscheidet,
und wobei das Ziellicht und Hintergrundlicht durch den Signalverarbeitungsabschnitt separat extrahiert werden, indem zum Extrahieren des Ziellichts elektrische Signale mit einem Muster von Änderungen, das mit einem Muster von Änderungen der Pulsfrequenz des gepulsten Laserlichts synchronisiert ist, verriegelt werden und zum Extrahieren des Hintergrundlichts elektrische Signale mit einem Muster von Änderungen, das mit einem Muster von Änderungen der Intensität des gepulsten Laserlichts synchronisiert ist, verriegelt werden.

## Revendications

1. Un dispositif de détection de fluorescence comprenant :
une section de génération (11) conçue pour générer de la lumière laser pulsée qui provoque une polarisation de spin et une relaxation de spin dans un luminophore qui émet de la fluorescence dont l'intensité varie en fonction de la résonance magnétique ;
une section de modulation conçue pour moduler une fréquence d'impulsion de la lumière laser pulsée ;
une section de modulation d'intensité (14) conçue pour moduler l'intensité de la lumière laser pulsée ;
une section de détection (16) comportant un élément d'imagerie destiné à recevoir de la lumière cible et de la lumière de fond, la lumière cible étant la fluorescence émise par le luminophore et la lumière de fond étant la fluorescence émise par un autre objet que le luminophore, et la section de détection étant conçue pour convertir, pour chaque pixel, la fluorescence reçue en signal électrique ; et
une section de traitement du signal (17) destinée à traiter les signaux électriques provenant de la section de détection et identifier la lumière cible et la lumière de fond,
dans lequel la section de modulation est conçue pour moduler la fréquence d'impulsion de la lumière laser pulsée en utilisant une onde porteuse ayant une première fréquence et une première phase,
dans lequel la section de modulation d'intensité est conçue pour moduler l'intensité de la lumière laser pulsée en utilisant une onde porteuse ayant une deuxième fréquence et une deuxième phase,
dans lequel la deuxième fréquence est différente de la première fréquence et/ou la deuxième phase est différente de la première phase, et dans lequel la section de traitement du signal (17) est conçue pour extraire séparément la lumière cible et la lumière de fond, dans la mesure où, pour extraire la lumière cible, des signaux électriques présentant un motif de variations qui se synchronise avec un motif de variations de la fréquence d'impulsion de la lumière laser pulsée sont verrouillés, et pour extraire la lumière de fond, des signaux électriques présentant un motif de variations qui se synchronise avec un motif de variations de l'intensité de la lumière laser pulsée sont verrouillés.

2. Le dispositif de détection de fluorescence selon la revendication 1, dans lequel la section de modulation est conçue pour moduler la fréquence d'impulsion de la lumière laser pulsée dans une plage de 100 Hz à 200 MHz.

3. Le dispositif de détection de fluorescence selon l'une quelconque des revendications 1 et 2, dans lequel la section de modulation joue également le rôle de la section de modulation d'intensité.

4. Le dispositif de détection de fluorescence selon l'une quelconque des revendications 1 à 3, dans lequel l'amplitude de modulation de la lumière de fond est inférieure à l'amplitude de modulation de la lumière cible, l'amplitude de modulation de la lumière de fond étant une variation d'intensité de la lumière de fond, laquelle variation est provoquée par la modulation par la section de modulation d'intensité de l'intensité de la lumière laser pulsée, et l'amplitude de modulation de la lumière cible étant une variation de l'intensité de la lumière cible, laquelle variation est provoquée par la modulation par la section de modulation de la fréquence d'impulsion de la lumière laser pulsée.

5. Le dispositif de détection de fluorescence selon la revendication 4, dans lequel l'amplitude de modulation de la lumière de fond provoquée par la modulation de l'intensité de la lumière laser pulsée par la section de modulation d'intensité ne dépasse pas 5 %.

6. Le dispositif de détection de fluorescence selon l'une quelconque des revendications 1 à 5, dans lequel le luminophore contient au moins un élément choisi dans le groupe constitué par : un centre NV d'un diamant, lequel centre NV contient un atome d'azote qui remplace un atome de carbone et une lacune qui est adjacente à l'atome d'azote ; un centre SiV d'un diamant, lequel centre SiV contient un atome de silicium qui remplace un atome de carbone et une lacune qui est adjacente à l'atome de silicium ; un centre V_{Si} V_{C} d'un cristal de carbure de silicium, lequel centre V_{Si} V_{C} contient une lacune qui remplace un atome de silicium et une lacune qui est adjacente à la lacune ; et un centre V_{Si} d'un cristal de carbure de silicium, lequel centre V_{Si} contient une lacune qui remplace un atome de silicium.

7. Un procédé de détection de fluorescence comprenant les étapes suivantes :
génération, par une section de génération, de lumière laser pulsée qui provoque une polarisation de spin et une relaxation de spin dans un luminophore qui émet de la fluorescence dont l'intensité varie en fonction de la résonance magnétique ;
modulation, par une section de modulation, d'une fréquence d'impulsion de la lumière laser pulsée ;
modulation, par une section de modulation d'intensité, d'une intensité de la lumière laser pulsée ;
réception, par une section de détection comportant un élément d'imagerie, de lumière cible et de lumière de fond, la lumière cible étant la fluorescence émise par le luminophore et la lumière de fond étant la fluorescence émise par un autre objet que le luminophore, et conversion (S22), pour chaque pixel, de la fluorescence reçue en signal électrique ; et
traitement des signaux électriques provenant de la section de détection et identification de la lumière cible et de la lumière de fond par une section de traitement du signal,
dans lequel la section de modulation module la fréquence d'impulsion de la lumière laser pulsée en utilisant une onde porteuse ayant une première fréquence et une première phase,
dans lequel la section de modulation d'intensité module l'intensité de la lumière laser pulsée en utilisant une onde porteuse ayant une deuxième fréquence et une deuxième phase,
dans lequel la deuxième fréquence est différente de la première fréquence et/ou la deuxième phase est différente de la première phase,
et dans lequel la lumière cible et la lumière de fond sont extraites séparément par la section de traitement du signal, dans la mesure où, pour extraire la lumière cible, des signaux électriques présentant un motif de variations qui se synchronise avec un motif de variations de la fréquence d'impulsion de la lumière laser pulsée sont verrouillés, et pour extraire la lumière de fond, des signaux électriques présentant un motif de variations qui se synchronise avec un motif de variations de l'intensité de la lumière laser pulsée sont verrouillés.
